# EUROPEAN PATENT SPECIFICATION

(11) **EP 4 053 916 B1**
(45) Date of publication and mention of the grant of the patent: **03.07.2024**
(21) Application number: 21159962.6
(22) Date of filing: 01.03.2021
(51) Int. Cl.: H01L 29/78, H01L 29/423, H01L 29/51, H01L 29/16, H01L 29/739

(54) **POWER SEMICONDUCTOR DEVICE**
LEISTUNGSHALBLEITERBAUELEMENT
DISPOSITIF DE SEMI-CONDUCTEUR D'ALIMENTATION

(43) Date of publication of application: 07.09.2022
(73) Proprietor: Hitachi Energy Ltd, 8050 Zürich (CH)
(72) Inventor: ROMANO, Gianpaolo, 5400 Baden (CH); KNOLL, Lars, 5607 Hägglingen (CH); ARANGO, Yulieth, 8045 Zürich (CH); WIRTHS, Stephan, 8800 Thalwil (CH); MIHAILA, Andrei, 5415 Rieden (CH)
(74) Representative: Epping - Hermann - Fischer

(56) References cited:
- US-A1- 2016 064 550
- US-A1- 2016 225 905
- US-A1- 2020 259 012

## Description

A power semiconductor device is provided.

Document WO 2014/204491 A1 refers to a low loss power SiC MOSFET.

Document US 8,436,367 B1 refers to a SiC power vertical DMOS with increased safe operating area.

Document US 2016/0064550 A1 provides an insulated gate type switching device which includes: a first region being of a first conductivity type; a body region being of a second conductivity type and in contact with the first region; a second region being of the first conductivity type and separated from the first region by the body region; an insulating film being in contact with the first region, the body region and the second region; and a gate electrode facing the body region via the insulating film. The body region includes a first body region and a second body region. The first body region has a theoretical threshold level Vth larger than that of the second body region.

Documents US 2016/0225905 A1, US 2020/0259012 A1, WO 2014/204491 A1 and US 4 190 850 A refer to semiconductor devices comprising a gate electrode.

A problem to be solved is to provide a power semiconductor device having an improved switching behavior.

This object is achieved by a power semiconductor device as defined in the independent patent claim. Exemplary further developments constitute the subject-matter of the dependent claims.

The power semiconductor device may be based on a wide bandgap material and comprises a gate electrode and a gate insulator that may fully or partially comprise a high-k material. The gate insulator has a varying dielectric capacitance which is, for example, larger at edges than in a central region. The wide bandgap material is for example, based on SiC.

By means of such a gate insulator, a lower resistance in an on-state of the device and also comparably short switching times can be maintained.

The power semiconductor device comprises a semiconductor body having at least one source region. Further, the power semiconductor device comprises a gate electrode at the semiconductor body and a gate insulator between the semiconductor body and the gate electrode. At least one well region is located at the at least one source region and at the gate insulator. The gate insulator has a varying dielectric capacitance, the dielectric capacitance may be in each case a quotient of a total dielectric constant and of a geometric thickness of the gate insulator at a specific location thereof. The dielectric capacitance is larger at the at least one well region than in remaining regions of the gate insulator.

In other words, the dielectric capacitance is c_{dielectric} = ε ε₀/t, with ε being the relative dielectric constant, ε₀ being the vacuum permittivity and t being the geometric thickness of the gate insulator. c_{dielectric} is lower on a junction field effect transistor region, JFET region for short, than on a channel region. The channel region may refer to a region where the at least one well region is close to the gate insulator, and the JFET region may refer to a central region of the gate electrode, seen in top view of the gate electrode.

The relative dielectric constant may also be referred to as relative permittivity, abbreviated ε or κ, respectively, or also simply referred to as k. The relative dielectric constant, for example, refer to the value measured at a temperature of 300 K and, for example, at a frequency of 1 kHz, but not limited to that.

Here and in the following, the term `gate insulator' may refer to the insulator beneath the gate electrode, i.e between the gate electrode and the semiconductor body. For example, further electrically insulating material on top of the gate electrode, that is, on a side of the gate electrode remote from the semiconductor body, and the like may not be meant by the term `gate insulator', but only the insulating material that ensures electric insulation immediately between the gate electrode and the semiconductor body.

The term `source region' may refer both to a source in a field-effect transistor and to an emitter in a bipolar transistor.

Thus, the power semiconductor device can be a silicon carbide (short: SiC) metal-oxide-semiconductor field-effect transistor (short: MOSFET) or a SiC metal-insulator-semiconductor field-effect transistor (short: MISFET) with variable dielectric regions for improved switching behavior. For example, a power MOSFET based on silicon carbide material is described. The gate insulator is partially or completely formed with at least one high-k material. In addition, the gate insulator is divided into two sections: A first one overlapping a channel area, and a second one extending on a JFET region. The dielectric extending on the JFET region can be made with a different material and/or a different layer thickness, compared to the first one. The described gate structure allows to exploit the advantages of a high-k dielectric in conduction without slowing down the device switching.

Otherwise, using a high permittivity material increases a capacitance seen from a gate terminal, that would turn into slower switching speeds. Using the described two-zone gate insulator with different materials and/or thicknesses allows to decrease the gate capacitance.

Silicon carbide power semiconductor devices may replace their silicon-based counterparts, for example, in low voltage applications with voltages of 650 V to 1.2 kV. Even though the SiC market is mostly driven by low voltage devices, the use of ≥3.3kV SiC power MOSFETs for medium voltage and high voltage systems, like traction applications, has also attracted more attention. Despite superior material's properties, there are still some issues that have to be tackled before the widespread use of SiC power devices in different applications. For example, most of the effort are focused on improving the quality of the gate dielectric/silicon carbide interface. It is known, indeed, that during the oxidation process to form the gate insulator, like SiO₂, several interface trap states and defects are originated, that lay within the bandgap of SiC. These defects heavily degrade the inversion channel mobility due to charge trapping and Coulomb scattering mechanisms.

The use of high-k material for the gate insulator implies that, for the same applied voltage and dielectric thickness, the number of carriers in the inversion channel is higher. The result is a lower resistance between drain and source in a turned-on state, also referred to as R_{DS,ON}. In addition, it has also been proven that high-k gate dielectrics provide high threshold voltage stability and lower interface states density. However, one drawback of high permittivity materials is that the gate capacitance, for example, the gate-source capacitance C_{GS} and the gate-drain Miller capacitance C_{GD}, has a higher value, which turns into lower switching speeds.

Herein, an improved structure for the gate insulator is described. Compared with a gate dielectric having a constant dielectric capacitance, the structure described herein is divided in different regions: the first insulator gate regions extend on the channel region and are formed, for example, with at least one high-k material; the second insulator gate region corresponds to the JFET area with different configurations: it can be formed with SiO₂ having the same thickness like at the channel region, or it can be thicker and be formed either with SiO₂ or a high-k material, or combinations thereof. Hence, one design feature of the device described herein is to have a lower dielectric capacitance of the gate insulator extending on the JFET area, so to further decrease the gate capacitance.

According to at least one embodiment, the semiconductor body is of SiC. However, the semiconductor body can alternatively be of Si or of a high-bandgap compound semiconductor material like Ga₂O₃ or GaN.

According to at least one embodiment, the power semiconductor device is a field-effect transistor or an insulated gate bipolar transistor, IGBT for short. For example, the power semiconductor device described herein is or is comprised in, for example, a MOS-based SiC trench device or planar device such as MOSFETs and IGBTs. Hence, the power semiconductor device is or can be present in, for example, a device selected from the group comprising or consisting of a metal-oxide-semiconductor field-effect transistor (MOSFET), a metal-insulator-semiconductor field-effect transistor (MISFET), an insulated-gate bipolar transistor (IGBT).

The gate insulator comprises a first material and a second material. The second material has a higher relative dielectric constant than the first material and can consequently be a high-k material. For example, the ratio between the relative dielectric constants of the second material and the first material varies between 1.2 and 5, for example, by at least a factor of 1.2 or by at least a factor of 1.5 or by at least a factor of 2.5 and/or by at most a factor of 4.5. For example, the first material is SiO₂, and the second material is selected, for example, from the following group: Si₃N₄, Al₂O₃, Y₂O₃, ZrO₂, HfO₂, La₂O₃, Ta₂O₅, TiO₂.

According to at least one embodiment, only the second material is present directly on the channel region, that is, directly on the well region. It is possible that the first, low-k material is applied only at locations distant from the well region so that the first material may be limited to the JFET region.

The second material is present as a continuous layer. Said continuous layer can completely extend between the gate electrode and the semiconductor body. Hence, there may be no direct, straight connection line between the gate electrode and the semiconductor body without running through the second material, that is, the high-k material.

According to at least one embodiment, the first material is located at a side of the second material remote from the semiconductor body. In this case, the second material can be in direct contact with the semiconductor body, and the first material may be distant from the semiconductor body and not in direct contact with the semiconductor body. For example, the second material is applied to the semiconductor body first as the continuous layer and then the first material is applied in a structured manner, or vice versa.

According to at least one embodiment, the continuous layer of the second material has a constant geometric layer thickness. The term `constant geometric layer thickness' may tolerate thickness variations of at most 10% or of at most 5% of a maximum thickness of said layer. Hence, accidental thickness variations, for example, due to manufacturing tolerances, shall not be regarded as a varying thickness in the present context.

According to at least one embodiment, the second material is located at a side of the first material remote from the semiconductor body. In this case, both the first material and the second material can be in direct contact with the semiconductor body. For example, the first material is applied to the semiconductor body in a structured manner so that only part of the semiconductor body is covered by the first material in the later gate electrode region, and then the first material is applied, for example, as the continuous layer that may have a constant thickness in this case, too.

According to at least one embodiment, the gate insulator is of constant geometric thickness. In this case, the first material and the second material are located next to one another in a common plane. For example, both materials are applied directly on a top side of the semiconductor body with a constant thickness. For example, both materials are applied in a disjunctive and non-overlapping manner when seen in top view of the top side. The first and the second material may thus directly adjoin one another without overlapping each other. Otherwise, the first and second material may overlap, for example, due to a manufacturing process.

According to at least one embodiment, the gate insulator is of exactly one material. Hence, the gate insulator has a non-varying relative dielectric constant and consequently a varying geometric thickness.

According to at least one embodiment, the geometric thickness of the gate insulator is largest in a central part of the gate insulator, seen in cross-section. The term `cross-section' may refer to a plane perpendicular to the top side of the semiconductor body and perpendicular to a direction of main extent of the gate electrode, for example, if the gate electrode is a strip electrode, seen in top view of the top side. The central part of the gate insulator is that region of the gate insulator, which is in direct contact to the drift layer.

According to at least one embodiment, the gate electrode is of planar configuration. Hence, the gate electrode is located on a top side of the semiconductor body and the top side is of planar fashion. In this case, neither the gate electrode nor the gate insulator penetrate in the semiconductor body.

According to at least one embodiment, the gate electrode is of trench configuration. In this case, the gate electrode extends into a trench of the semiconductor body. For example, the gate insulator covers side walls of trench and a bottom of the trench and the gate electrode is embedded in the gate insulator in the trench.

According to at least one embodiment, the gate electrode reaches deeper into the semiconductor body than the at least one well region and/or than the at least one source region. Consequently, the gate insulator, too, has a depth greater than a depth of the at least one well region and/or than the at least one source region. 'Depth' may refer to a direction running away and in perpendicular to the top side of the semiconductor body.

According to at least one embodiment, the at least one well region and/or the at least one source region directly adjoins the trench. Hence, the at least one well region and/or the at least one source region can be in direct contact with the gate insulator at the side walls of the trench.

According to at least one embodiment, the gate insulator is composed of two, or of more than two, first gate insulator regions having the larger dielectric capacitance and of one, or of at least one, central, second gate insulator region having the smaller dielectric capacitance. This applies, for example, seen in cross-section perpendicular to the top side of the semiconductor body through the gate electrode. Seen in said cross-section, the first gate insulator regions can be located at edges of the gate electrode, and the second gate insulator region can be located at a middle portion of the gate electrode.

According to at least one embodiment, for example, seen in cross-section perpendicular to the top side of the semiconductor body through the gate electrode, the at least one well region is in direct contact only with at least one of the first gate insulator regions and not with the second gate insulator region. Thus, the at least one well region can be limited to the respective first gate insulator region having the higher dielectric capacitance.

According to at least one embodiment, the semiconductor body further comprises a drift region. The drift region and the at least one source region can be of a first conductivity type, for example, of n-conducting type and therefore can be n-doped. For example, the at least one source region and the at least one well region are embedded in the drift region so that a bulk of the semiconductor body may be composed of the drift region. The drift layer may have a homogeneous doping concentration.

According to at least one embodiment, the at least one well region is of a second conductivity type different from the first conductivity type. For example, the at least one well region is of p-conducting type and thus is p-doped. It is possible that the at least one well region completely separates the respective source region from the drift region within the semiconductor body so that there is no direct contact between the respective source region and the drift region.

According to at least one embodiment, for example, seen in cross-section perpendicular to the top side of the semiconductor body through the gate electrode, the only region of the semiconductor body the second gate insulator region is in contact with is the drift region. Hence, the second gate insulator region may be distant from the at least one well region and form the at least one source region.

According to at least one embodiment, for example, seen in cross-section perpendicular to the top side of the semiconductor body through the gate electrode, the first gate insulator regions are in contact with the at least one source region and/or with the at least one well region as well as with the drift region. Hence, the first gate insulator regions can be close to all these three regions of the semiconductor body. However, a proportion of the first gate insulator regions in contact with the drift region is, for example, smaller that a proportion being in contact with the at least one source region and/or with the at least one well region.

According to at least one embodiment, the semiconductor further comprises a collector layer. The collector layer is of the same conductivity type as the well region. The collector layer may be located at a bottom side of the semiconductor body opposite the top side. There can be one collector layer for all the source regions. A collector electrode can be directly applied to the collector layer. If there is a collector layer, the power semiconductor device can be an IGBT.

According to at least one embodiment, the semiconductor further comprises at least one drain region. The drain region is of the same conductivity type as the at least one source region. For example, the drain region is a layer at the bottom side. For example, the drift region is located between the top side and the drain region. There can be one common drain region for all the source regions. A drain electrode may be in direct contact with the at least one drain region. If there is a drain region, the power semiconductor device can be a MOSFET or a MISFET. The drain layer has a higher doping concentration than the drift layer.

According to at least one embodiment, a proportion of the second gate insulator region along an interface of the gate electrode facing the semiconductor body is at least 200 or is at least 300 or at least 40% and/or at most 80% or at most 70% or at most 600 of an overall extent of said interface. The interface may be a contact face between the gate insulator and the semiconductor body. The above-stated values apply, for example, seen in cross-section perpendicular to the top side of the semiconductor body, for example, along a shortest line across the gate electrode. If the gate electrode is of planar fashion, the interface may run along a straight line, and if the gate electrode is of trench design, the interface may be of U-shape when seen in cross-section.

According to at least one embodiment, seen in cross-section, the first gate insulator regions are located along the interface symmetrically around the second gate insulator region. Hence, there can be a line of mirror symmetry through the gate insulator concerning the design of the first and second gate insulator regions, seen in cross-section.

According to at least one embodiment, the geometric thickness of the overall gate insulator is at least 5 nm or at least 40 nm or at least 100 nm. Alternatively or additionally, this geometric thickness is at most 1.5 µm or at most 0.8 µm or at most 0.5 µm.

According to at least one embodiment, the semiconductor body comprises at least one plug. For example, the plug is in direct contact to the source electrode to provide an electric contact with the at least one assigned well region. For example, the at least one plug and the at least one well region are of the same conductivity type, wherein the at least one plug can be doped more strongly.

According to at least one embodiment, the power semiconductor device comprises at least two of the source regions and a source electrode. The source electrode is in electric contact, for example, in direct contact, with the at least two of the source regions. Hence, said at least two source regions can be on the same electric potential. As an option, the source electrode may also be in direct contact with the at least one plug.

According to at least one embodiment, seen in cross-section perpendicular to the top side, the gate electrode is located between two of the at least two source regions. Hence, two source regions can be assigned to one gate electrode. The source regions may be arranged in a symmetric manner next to the respective gate electrode.

According to at least one embodiment, seen in cross-section perpendicular to the top side, the source electrode partially or completely covers the gate electrode on a side remote from the semiconductor body. The source electrode and the gate electrode are electrically insulated by one or more layers of one or more insulating materials. Hence, the source electrode can be a common electrode of the at least two assigned the source regions.

According to at least one embodiment, the power semiconductor device is of a cell design. This may mean that, seen in top view, the gate electrode is of, for example, but not limited to, square or nearly square shape. Otherwise, the power semiconductor device can be of a stripe design so that the gate electrode is considerably longer than wide. Both in the cell design and the stripe design, there can be a plurality of the gate electrodes.

According to at least one embodiment, the power semiconductor device is a power device. For example, the power semiconductor device is configured for a maximum current through the drain electrode or the collector layer of at least 1 A or of at least 20 A. Alternatively or additionally, the power semiconductor device is configured for a maximum voltage of at least 0.1 kV or of at least 0.6 kV or of at least 1.2 kV.

The power semiconductor device is, for example, for a power module in a vehicle to convert direct current from a battery to alternating current for an electric motor, for example, in hybrid vehicles or plug-in electric vehicles. Moreover, the power semiconductor device can be a fuse, for example, in a vehicle like a car. It is also possible that the power semiconductor device is used in an electric train or in railway systems, for example, as a converter.

A power semiconductor device is explained in greater detail below by way of exemplary embodiments with reference to the drawings. Elements which are the same in the individual figures are indicated with the same reference numerals. The relationships between the elements are not shown to scale, however, but rather individual elements may be shown exaggeratedly large to assist in understanding.

In the figures:
Figures 1 and 2 are schematic perspective views of exemplary embodiments of power semiconductor devices not covered by the claims but useful for understanding the invention,
Figures 4, 5, 8, 9, 10, 13 and 14 are schematic sectional views of exemplary embodiments of power semiconductor devices described herein,

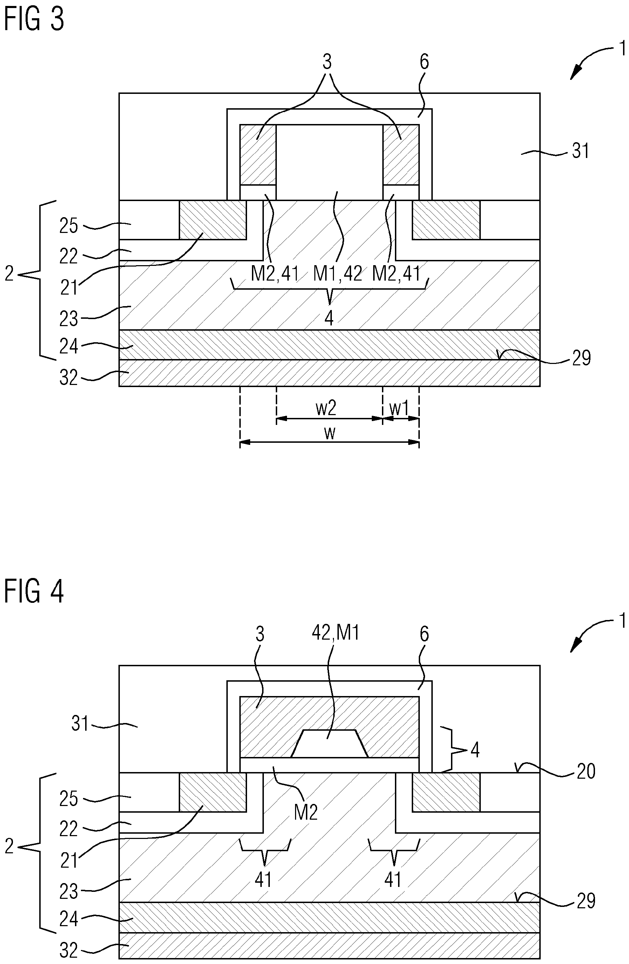

Figures 3, 6, 7, 11 and 12 are schematic sectional views of exemplary embodiments of power semiconductor devices described herein not covered by the claims but useful for understanding the invention,

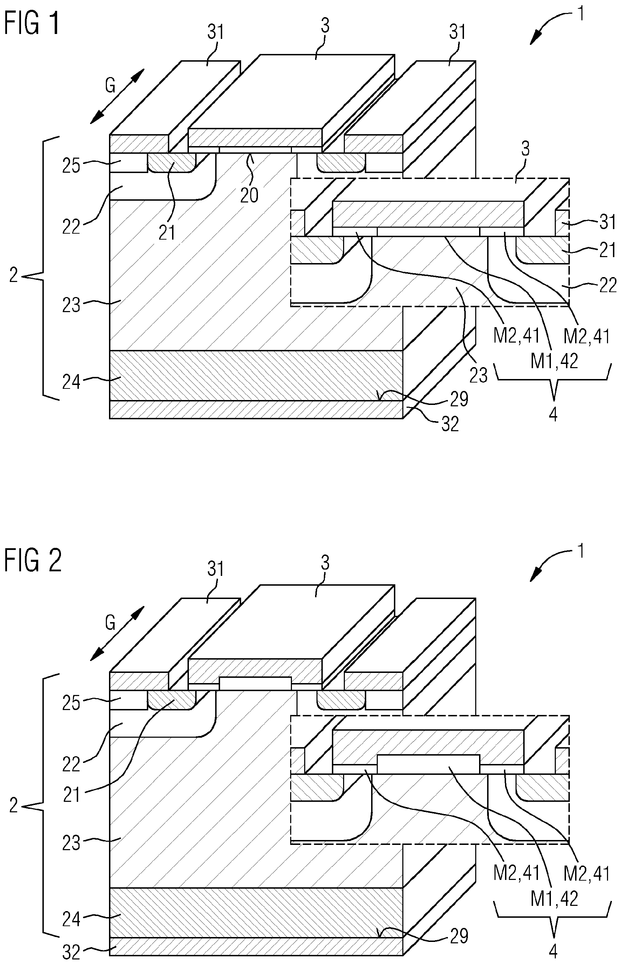

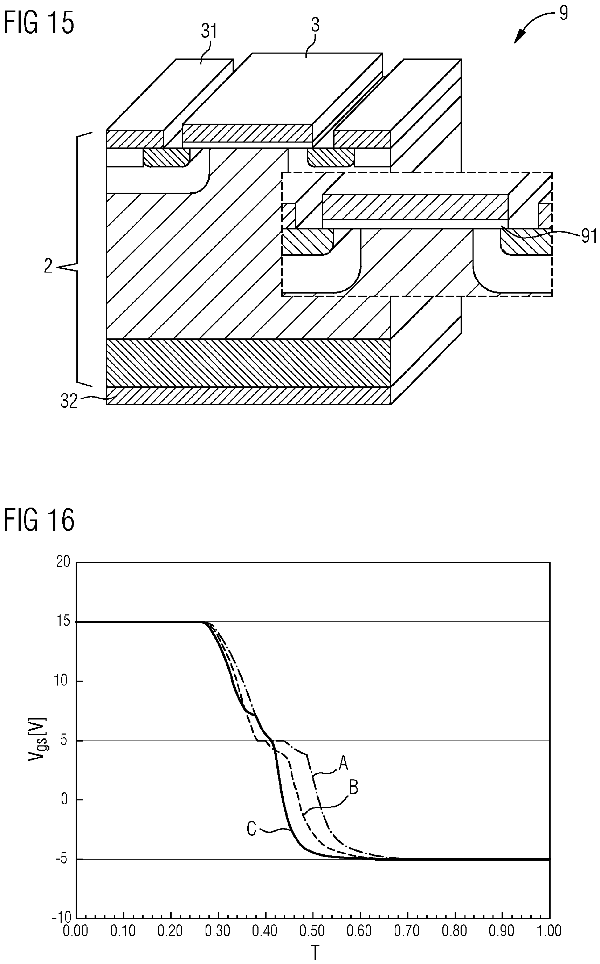

Figure 15 is a schematic perspective view of a modified power semiconductor device not covered by the claims but useful for understanding the invention, and Figures 16 to 19 show simulation data for the exemplary embodiments of Figures 1 and 2.

In Figure 1, an exemplary embodiment of a power semiconductor device 1 is illustrated. The power semiconductor device 1 comprises a semiconductor body 2. The semiconductor body 2 comprises two source regions 21 at a top side 20 of the semiconductor body 2, and two well regions 22 at the source regions 21. Further, there is a drift region 23 in which the well regions 22 and the source regions 21 are embedded. The well regions 22 separate the source regions 21 from the drift region 23. If the power semiconductor device 1 is a MISFET or a MOSFET, then there can be an optional drain region 24 at a bottom side 29 of the semiconductor body 2 opposite the top side 20. As an option, there can be a buffer layer between the drift region 23 and the drain region 24, not shown.

As an option, there are two plugs 25 at the top side 20 to provide electric contact with the well regions 22. For example, the source regions 21 as well as the well regions 22 are electrically contacted by a source electrode 31. The drain region 24 may electrically be contacted by a drain electrode 32.

For example, the source regions 21 and the drain region 24 are n⁺-doped and the drift region 23 is n⁻-doped; the well regions 22 are p-doped and the optional plugs 25 are p⁺-doped. Otherwise, the doping types could all be inverted.

For example, maximum doping concentrations of the source regions 21, the drain region 24 and the plugs are at least 1 × 10¹⁸ cm⁻³ or at least 5 × 10¹⁸ cm⁻³ or at least 1 × 10¹⁹ cm⁻³ and/or at most 5 × 10²⁰ cm⁻³ or at most 2 × 10²⁰ cm⁻³ or at most 1 × 10²⁰ cm⁻³. Further, a maximum doping concentration of the well region 22 may be at least 5 × 10¹⁶ cm⁻³ or at least 1 × 10¹⁷ cm⁻³ and/or at most 5 × 10¹⁹ cm⁻³ or at most 5 × 10¹⁸ cm⁻³. Depending on the voltage class of the power semiconductor device 1, a maximum doping concentration of the drift region 23 may be at least 1 × 10¹⁴ cm⁻³ or at least 5 × 10¹⁴ cm⁻³ or at least 1 × 10¹⁵ cm⁻³ and/or at most 1 × 10¹⁷ cm⁻³ or at most 5 × 10¹⁶ cm⁻³ or at most 1 × 10¹⁶ cm⁻³.

The semiconductor body 2 may be composed of a substrate and of an epitaxially grown semiconductor section, or only of an epitaxially grown semiconductor section. Depending on the presence of a substrate, for example, the substrate is included in the drain region 24, and the drift region 23 is grown on top thereof. A drift region thickness can range, for example, from 3 µm to 0.2 mm and/or a drain region thickness may be between 1 µm and 0.5 mm inclusive.

Moreover, the power semiconductor device 1 includes a gate electrode 3 at the top side 20 located between the well regions 22 at the drift region 23. For example, the gate electrode 3 is of a metal or of a highly conductive semiconductor material like poly-Si.

Between the gate electrode 3 and the semiconductor body 2, there is a gate insulator 4. The gate insulator 4 comprises two different zones, that is, two first gate insulator regions 41 and one second gate insulator region 42. The second gate insulator region 42 has a smaller dielectric capacitance than the first gate insulator regions 41. At every specific location of the gate insulator 4, the respective local dielectric capacitance refers to a quotient of a total dielectric constant and a local geometric thickness of a local material. In case of the planar design of Figure 1, the geometric thickness is measured perpendicular to the planar top side 20.

According to Figure 1, the gate insulator 4 is of constant geometric thickness so that all the first and second gate insulator regions 41, 42 have the same geometric thickness. To achieve different dielectric capacitances, the first gate insulator regions 41 are of a second material M2 having a higher relative dielectric constant than a first material M1 of the second gate insulator region 42. The second material M2 may be referred to as a high-k material. For example, the first material M1 is SiO₂, and the second material M2 is Y₂O₃, ZrO₂, HfO₂, La₂O₃, Ta₂O₅ or TiO₂. For example, the ration of dielectric capacitance of the first gate insulator regions 41 and the dielectric capacitance of the second gate insulator region 42 is at least 1.2 and/or at most 10.

The second gate insulator region 42 is in contact with the semiconductor body 2 only at the drift region 23 whereas the first gate insulator regions 41 touch the source regions 21, the well regions 22 and, for example, to a less proportion, the drift region 23. The first gate insulator regions 41 are arranged in a mirror symmetric manner next to the second gate insulator region 42. All the first gate insulator regions 41 and the second gate insulator regions 42 are located in a plane parallel to and directly on the top side 20.

Other than shown in Figure 1, the drain electrode 32 may be led to the top side 20 by means of a via or may be located on the top side 20 as well, for example, by having the drain layer 24 locally exposed by means of a recess, not shown.

The gate electrode 3 and, thus, the gate insulator 4 may be of strip shape so that a length of the gate electrode 3 along a length direction G is larger than a width of the gate electrode 3. Otherwise, the power semiconductor device may be of a cell design so that the gate electrode 3 is of, but not limited to, square shape or approximately of square shape. The cross-sections below are perpendicular to the length direction G.

In the exemplary embodiment of Figure 2, the second gate insulator region 42 has a larger geometric thickness than the first gate insulator regions 41. Accordingly, the first gate insulator regions 41 and the second gate insulator regions 42 may be of the same or of different materials because the different dielectric capacitances can be achieved by the different geometric thicknesses. For example, the first gate insulator regions 41 on the well regions 22 are of a high-k material, that is, of the second material M2, and the second gate insulator region 42 may be of the first material M1 like SiO₂.

The overall stack of gate insulator 4 and gate electrode 3 together may be of constant thickness so that the gate electrode 3 may be of U-shape when seen in cross-section.

Otherwise, the same as to Figure 1 also applies to Figure 2.

In the exemplary embodiment of Figure 3, the thickness of the second gate insulator region 42 corresponds to the thickness of the overall stack of gate insulator 4 and gate electrode 3. Hence, the gate electrode 3 can be limited to the first gate insulator regions 41. Seen in cross-section, the gate electrode 3 can be divided in two equal parts by the second gate insulator region 42. For example, the second gate insulator region 42 is of the first material M1 having a low k like SiO₂, or is if the second material M2 having a high k, and the first gate insulator regions 41 are of the second material M2 having a high k.

Moreover, the power semiconductor device 1 can include a top gate insulator region 6 located at a side of the gate electrode 3 remote from the semiconductor body 2. The top gate insulator region 6 may electrically separate the source electrode 31 from the gate electrode 3. Such a top gate insulator region 6 can also be present in the power semiconductor devices 1 of Figures 1 and 2.

For example, the gate insulator 4 has an overall width W which is, for example, at least 1 µm and/or at most 20 µm. Along the top side 20, the second gate insulator region 42 has a width W2 and each one of the first gate insulator regions 41 have a width W1 so that W = W2 + 2 x W1.

Otherwise, the same as to Figure 2 also applies to Figure 3.

According to Figure 4, the gate insulator 4 comprises a continuous layer of a constant thickness directly at the top side 20. For example, this layer is of the second, high-k material M2. On a side of this layer remote from the top side 20, there is a coating, for example, of the first material M1. The coating of the first material M1 has a smaller width than the layer of the second material M2; it is also possible that both the layer and the coating are of the same material, for example, of the second material M2.

For example, seen in cross-section, the coating can have a trapezoidal shape so that it becomes narrower in the direction away from the top side 20. The overall stack of gate insulator 4 and gate electrode 3 together may be, for example, of constant thickness like in Figure 2.

Otherwise, the same as to Figures 1 to 3 also applies to Figure 4.

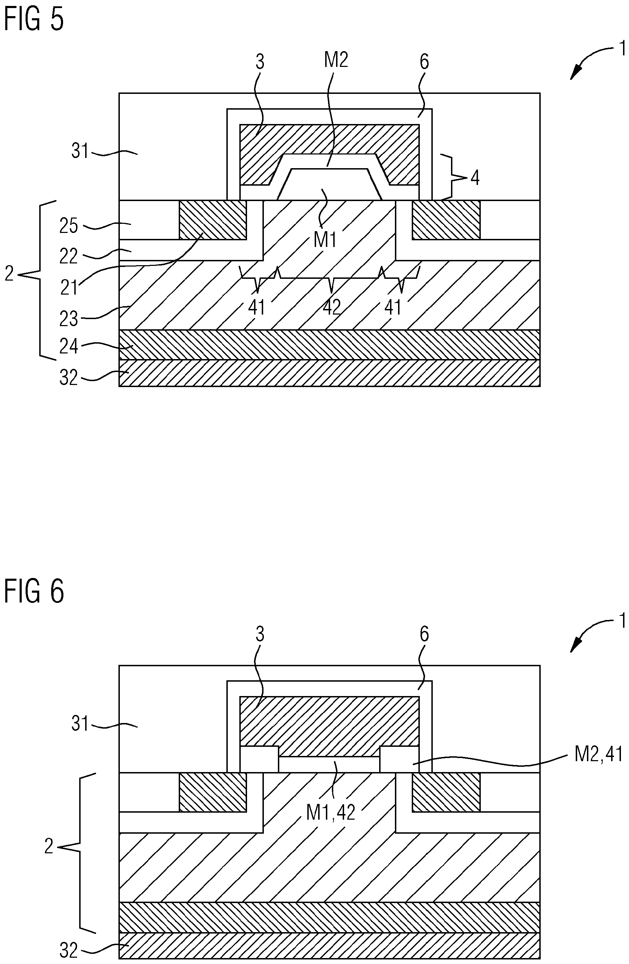

Also the gate insulator 4 of Figure 5 comprises the coating and the layer. Contrary to Figure 4, the coating is applied directly on the top side 20 and the layer completely covers the coating as well as part of the top side 20. Again, the layer may be of constant thickness.

Otherwise, the same as to Figure 4 also applies to Figure 5.

According to Figure 6, the first gate insulator regions 41 have a larger geometric thickness than the second gate insulator region 42, for example, due to manufacturing issues. To achieve the desired dielectric capacitances, this can be compensated for by choosing the first material M1 for the second gate insulator region 42 and the second material M2 for the first gate insulator regions 41. Hence, the relative dielectric constants of the materials M1, M2 may compensate for the geometric thicknesses of the first and second gate insulator regions 41, 42.

Otherwise, the same as to Figures 1 to 5 also applies to Figure 6.

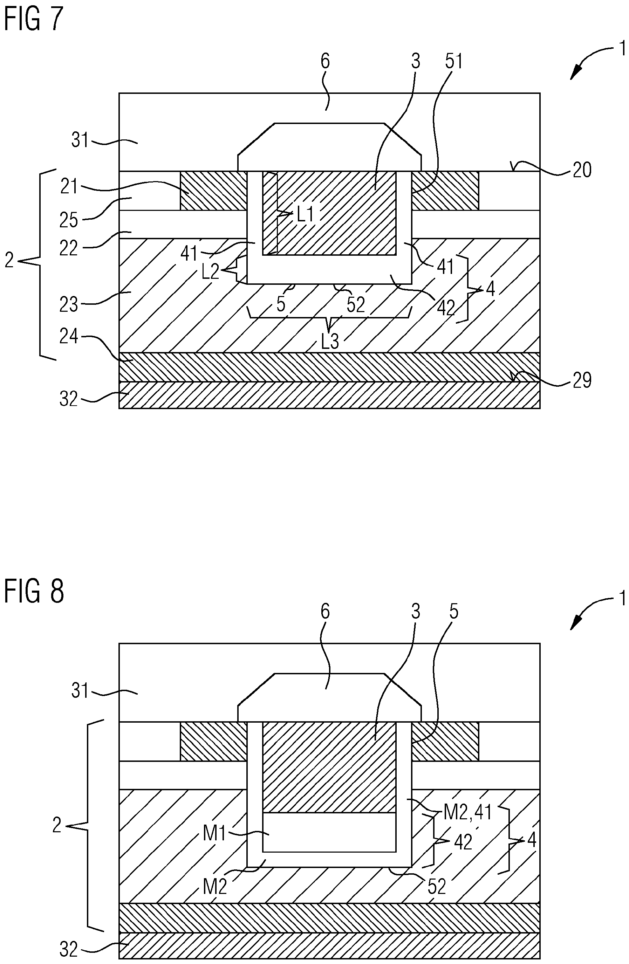

According to Figure 7, the power semiconductor device 1 is of trench design and, thus, there is a trench 5 in the semiconductor body 2 running towards the bottom side 29. The gate electrode 3 and the gate insulator 4 are predominantly or completely located in the trench 5. The trench 5 runs closer to the bottom side 29 than the well regions 22 that directly adjoin the trench 5 and, hence, the gate insulator 4. The gate electrode 3 can be covered by the top gate insulator region 6 to separate the gate electrode 5 from the source electrode 31.

At side walls 51 of the trench 5, there are the first gate insulator regions 41, and at a trench bottom 52 there is the second gate insulator region 42. Along the side walls 51, the first gate insulator regions 41 have a first length L1. A depth of the trench 5 corresponds to a sum of the first length L1 and a second length L2. A width of the trench 5 corresponds to a third length L3. For example, the length L2 is larger than a thickness of the first gate insulator regions 41, seen perpendicularly to the sidewall or the channel.

That is, seen in cross-section, an interface between the gate insulator 4 and the semiconductor body 2 has an overall length L = L1 + L2 + L3 + L2 + L1, whereas the second gate insulator region 42 has consequently a length L* = L2 + L3 + L2. At the trench bottom 52, a geometric thickness of the second gate insulator region 42 is L2.

The first and the second gate insulator regions 41, 42 can be of the same material, for example, of the second material M2.

Otherwise, the same as to Figures 1 to 6 also applies to Figure 7.

According to Figure 8, there is the layer of constant thickness on all the side walls 51 and the trench bottom 52. On this layer and on the trench bottom 52 there is the coating to define the second gate insulator region 42. For example, the coating for the second gate insulator region 42 is of the first material M1 and the layer predominantly for the first gate insulator regions 41 are of the second material M2.

Otherwise, the same as to Figure 7 also applies to Figure 8.

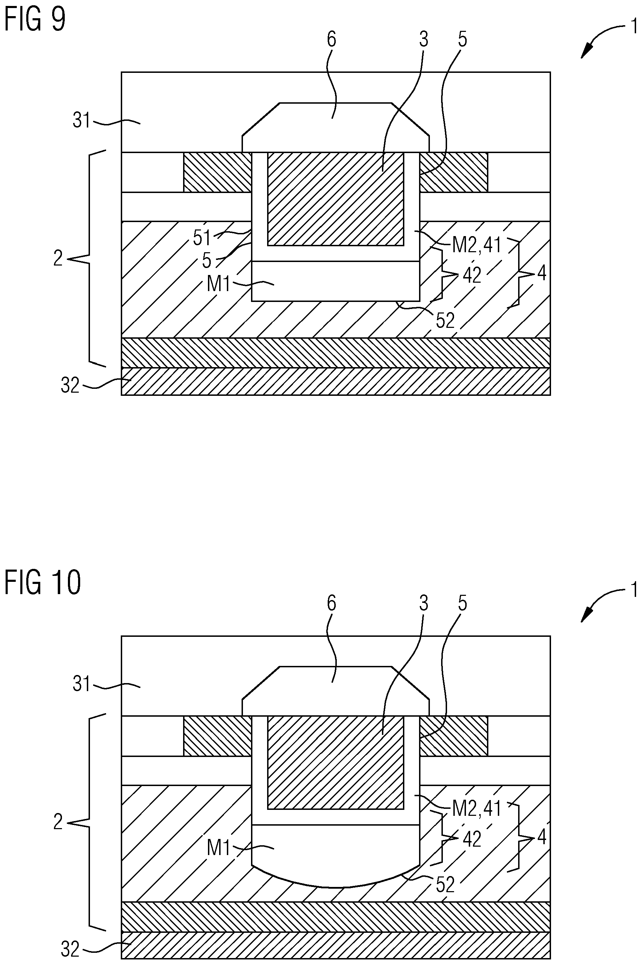

In the embodiment of Figure 9, first the coating is applied to the trench bottom 52 and then the layer is applied on the coating and on the remaining parts of the side walls 51. For example, the coating for the second gate insulator region 42 is of the first material M1 and the layer predominantly for the first gate insulator regions 41 are of the second material M2.

Otherwise, the same as to Figures 7 and 8 also applies to Figure 9.

According to Figure 10, the coating is of varying thickness, for example, to compensate for a curved trench bottom 52. In this context it is noted that in Figures 7 to 12 the trench 5 is illustrated in an idealized manner having a rectangular cross-section. However, due to an etching process, the trench 5 may have a trapezoidal shape or a rectangular shape with rounded corners, too, seen in cross section.

Otherwise, the same as to Figures 7 to 9 also applies to Figure 10.

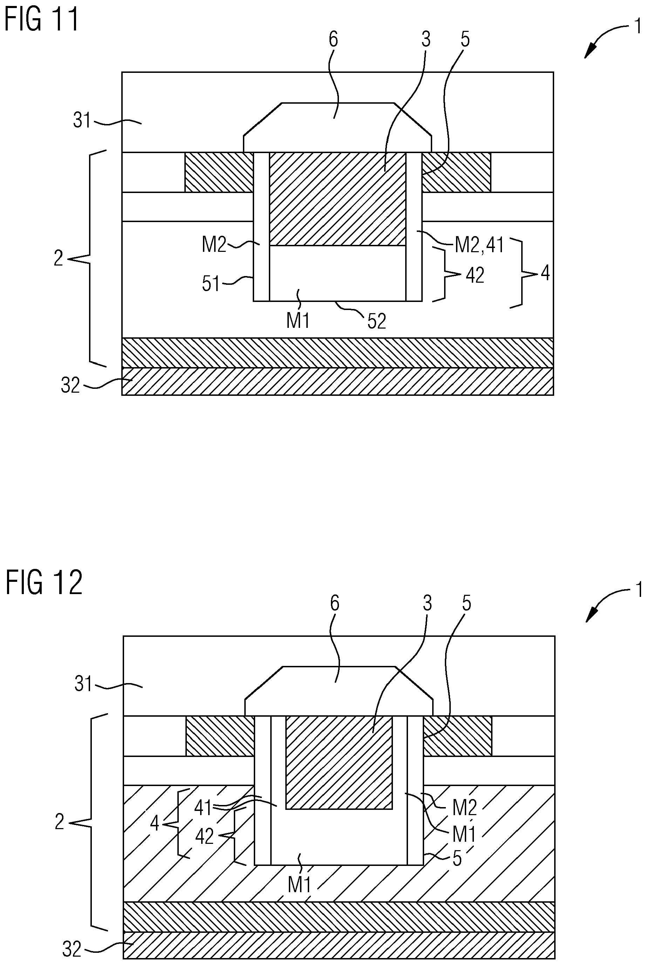

In the embodiment of Figure 11, the side walls 51 of the trench 5 are provided with the layer of constant thickness, for example, of the second material M2 to define the first gate isolator regions 41. For the second gate isolator region 42, at the trench bottom 52 the first material M1 is applied. Additionally or alternatively, each the side walls 51 and the trench bottom 52 can essentially be covered with only the second material M2.

Otherwise, the same as to Figures 7 to 10 also applies to Figure 11.

According to Figure 12, again the side walls 51 are coated with the second material M2 and the trench bottom 52 is covered with the first material M1. Other than in Figure 11, the first material M1, for example, extends as a thin layer also to the other material on the side walls 51.

Otherwise, the same as to Figures 7 to 11 also applies to Figure 12.

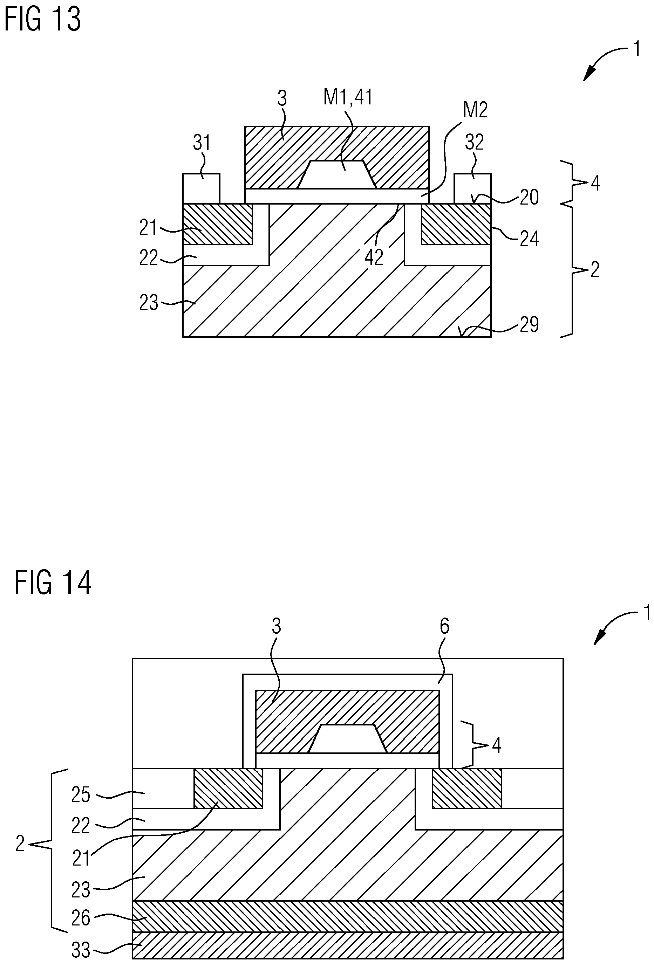

In the power semiconductor device 1 of Figures 1 to 12 current flows from the source regions 21 to the drain region 24 essentially in a vertical direction, that is, form the top side 20 to the bottom side 29. Contrary to that, in Figure 13 both the drain region 24 and the source region 21 are located at the top side 20.

Otherwise, the same as to Figures 1 to 6 also applies to Figure 13. For example, the different gate insulator designs of Figures 1 to 6 can likewise be used for the source-drain design of Figure 13.

In Figures 1 to 13 the power semiconductor devices 1 are MISFETs or MOSFETs. The power semiconductor device 1 of Figure 14 is an IGBT. Thus, at the bottom side 29 there is a collector layer 26 which is of the same conductivity type as the well layer 22, for example, p-doped. There can be a buffer layer between the drift region 23 and the collector layer 26, not shown. For example, for the doping concentration of the collector layer 26 the same applies as to the optional plug 25. Consequently, at a side of the collector layer 26 remote from the gate electrode 4 there is a collector electrode 33.

Although the IGBT of Figure 14 is of the planar design, the trench designs of Figures 7 to 14 can be applied to IGBTs like in Figure 14, too. Hence, otherwise the same as to Figures 1 to 12 also applies to Figure 14.

In Figure 15, a modified semiconductor device 9 is shown. The modified semiconductor device 9 comprises a modified gate insulator 91 which has a constant dielectric capacitance and, thus, a constant effective thickness. Compared with the power semiconductor devices 1 of Figures 1 to 14, the modified semiconductor device 9 of Figure 15 has a decreased, that is, slower, switching behavior.

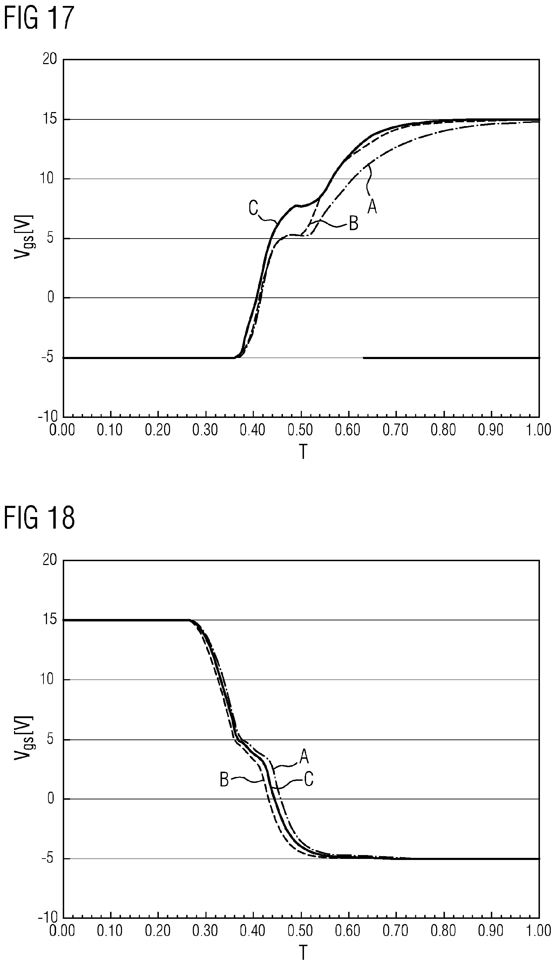

To prove the positive effect of the gate insulator design described herein, in Figures 16 to 19 Technology Computer-Aided Design, TCAD, simulations are illustrated considering power semiconductor devices 1 configured for a voltage of 1.2 kV. Figures 16 and 17 refer to the power semiconductor device 1 of Figure 1, and Figures 18 and 19 refer to the power semiconductor device 1 of Figure 2. The simulated circuit is a standard used for inductive load switching, ILS, that is, the device under test having as load an inductor with a freewheeling diode. The supply voltage was set to 600 V and the load current to 50 A, as an example.

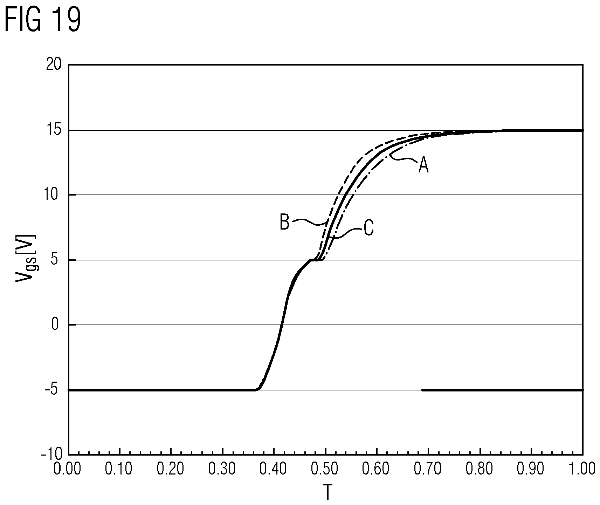

The curves C refer to the respective gate insulator 4 described above in context of Figures 1 and 2, wherein the first gate insulator region 41 is of a high-k material and the second gate insulator region 42 is of SiO₂. The curves A refer to the case of a modified gate insulator 91 having the same geometry as in Figures 1 and 2, but using only the high-k material, and curves B accordingly refer to a modified gate insulator 91 using SiO₂ only. Figures 16 and 18 illustrate the gate-to-source voltage Vgs depending on the time T during a turn-off phase, and Figures 17 and 19 during a turn-on phase.

From Figures 16 to 19 it can be seen that employing the gate insulator structure described herein, it is possible to lower the switching times at least compared to the case of a full high-k gate insulator design.

### List of Reference Signs

- 1: power semiconductor device
- 2: semiconductor body
- 20: top side
- 21: source region
- 22: well region
- 23: drift region
- 24: drain region
- 25: plug
- 26: collector layer
- 29: bottom side
- 3: gate electrode
- 31: source electrode
- 32: drain electrode
- 33: collector electrode
- 4: gate insulator
- 41: first gate insulator region
- 42: second gate insulator region
- 5: trench
- 51: side wall
- 52: trench bottom
- 6: top gate insulator region
- 9: modified semiconductor device
- 91: modified gate insulator
- A: simulation data for use of high-k material only
- B: simulation data for use of SiO₂ only
- C: simulation data for use of the first and the second gate insulator regions
- G: length direction of the gate electrode
- L1: first length of the first gate insulator region
- L2: second length
- L3: third length
- M1: material with lower relative dielectric constant
- M2: material with higher relative dielectric constant
- T: time in arbitrary units
- Vgs: gate-source voltage in V
- W: width of the overall gate insulator
- W1: width of the first gate insulator region
- W2: width of the second gate insulator region

## Claims

1. A power semiconductor device (1) comprising:
- a semiconductor body (2),
- at least one source region (21) in the semiconductor body (2),
- a gate electrode (3) at the semiconductor body (2),
- a gate insulator (4, 41, 42) between the semiconductor body (2) and the gate electrode (3), and
- at least one well region (22) at the at least one source region (21) and at the gate insulator (4, 41, 42),
wherein
- the gate insulator (4, 41, 42) has a varying dielectric capacitance, the dielectric capacitance is in each case a quotient of a dielectric constant and of a geometric thickness of the gate insulator (4, 41, 42) at a specific location thereof,
- the dielectric capacitance is larger at the at least one well region (22) than in remaining regions of the gate insulator (4, 42),
- seen in cross-section, the gate insulator (4, 41, 42) is composed of two first gate insulator regions (41) having the larger dielectric capacitance and of a central, second gate insulator region (42) having the smaller dielectric capacitance, **characterised in that**,
the at least one well region (22) is in direct contact only with the first gate insulator regions (41) and not with the second gate insulator region (42),
- the gate insulator (4, 41, 42) comprises a first material (M1) and a second material (M2), the second material (M2) has a higher relative dielectric constant than the first material (M1), and
- the second material (M2) is a continuous layer completely extending between the gate electrode (3) and the semiconductor body (2).

2. The power semiconductor device (1) according to the preceding claim,
wherein the semiconductor body (2) is of a wide bandgap material or of silicon carbide.

3. The power semiconductor device (1) according to the preceding claim,
wherein the power semiconductor device (1) is a field-effect transistor or an insulated gate bipolar transistor.

4. The power semiconductor device (1) according to any one of the preceding claims,
wherein the first material (M1) is located at a side of the second material (M2) remote from the semiconductor body (2), wherein the semiconductor body (2) is in direct contact with the second material (M2) but not with the first material (M1), and
wherein the continuous layer of the second material (M2) has a constant geometric layer thickness.

5. The power semiconductor device (1) according to any one of claims 1 to 3,
wherein the second material (M2) is located at a side of the first material (M1) remote from the semiconductor body (2) so that both the first material (M1) and the second material (M2) are in direct contact with the semiconductor body (2).

6. The power semiconductor device (1) according to any one of claims 1 to 3,
wherein the gate insulator (4, 41, 42) is of constant geometric thickness and the first material (M1) and the second material (M2) are located next to one another in a common plane, and
wherein the first material (M1) and the second material (M2) are in direct contact with the semiconductor body (2).

7. The power semiconductor device (1) according to any one of the preceding claims,
wherein the gate electrode (3) is of planar configuration so that the gate electrode (3) is located on a top side (20) of the semiconductor body (2) and the top side (20) is of planar fashion.

8. The power semiconductor device (1) according to any one of claims 1 to 6,
wherein the gate electrode (3) is of trench configuration so that the gate electrode (3) extends into a trench (5) of the semiconductor body (5), the gate electrode (3) reaches deeper into the semiconductor body (2) than the at least one well region (22), and the at least one well region (22) directly adjoins the trench (5).

9. The power semiconductor device (1) according to any one of the preceding claims,
wherein the semiconductor body further comprises a drift region (23),
wherein the drift region (23) and the at least one source region (21) are of a first conductivity type, and the at least one well region (22) is of a second conductivity type different from the first conductivity type,
wherein the only region of the semiconductor body (2), with which the second gate insulator region (42) is in contact with, is the drift region (23), and
wherein, seen in cross-section, the first gate insulator regions (41) are in contact with the at least one source region (21) and with the at least one well region (22) as well as with the drift region (23).

10. The power semiconductor device (1) according to any one of the preceding claims,
wherein a proportion of the second gate insulator region (42) along an interface of the gate electrode (3) facing the semiconductor body (2) is between 20% and 80% inclusive of an overall extent of said interface,
wherein, seen in cross-section, the first gate insulator regions (41) are located along said interface symmetrically around the second gate insulator region (42).

11. The power semiconductor device (1) according to any one of the preceding claims,
wherein the dielectric capacitance of the first gate insulator regions (41) is at least 1.4 times and at most 6 times the dielectric capacitance of the second gate insulator region (42).

12. The power semiconductor device (1) according to any one of the preceding claims,
wherein an overall geometric thickness of the gate insulator (4, 41, 42) is between 10 nm and 1.5 µm inclusive.

13. The power semiconductor device (1) according to any one of the preceding claims,
comprising at least two source regions (21) and a source electrode (31) which is in electric contact with the at least two of the source regions (21),
wherein, seen in cross-section,
- the gate electrode (3) is located between two of the at least two source regions (21), and
- the source electrode (31) covers the gate electrode (3) on a side remote from the semiconductor body (2) so that the source electrode (31) is a common electrode for the at least two source regions (21).

## Patentansprüche

1. Leistungshalbleitervorrichtung (1), umfassend:
- einen Halbleiterkörper (2),
- wenigstens ein Source-Gebiet (21) in dem Halbleiterkörper (2),
- eine Gate-Elektrode (3) bei dem Halbleiterkörper (2),
- einen Gate-Isolator (4, 41, 42) zwischen dem Halbleiterkörper (2) und der Gate-Elektrode (3) und
- wenigstens ein Wannengebiet (22) bei dem wenigstens einen Source-Gebiet (21) und bei dem Gate-Isolator (4, 41, 42),
wobei
- der Gate-Isolator (4, 41, 42) eine variierende dielektrische Kapazität aufweist, die dielektrische Kapazität in jedem Fall ein Quotient einer dielektrischen Konstante und einer geometrischen Dicke des Gate-Isolators (4, 41, 42) an einer speziellen Stelle davon ist,
- die dielektrische Kapazität bei dem wenigstens einen Wannengebiet (22) größer als in verbleibenden Gebieten des Gate-Isolators (4, 42) ist,
- der Gate-Isolator (4, 41, 42) bei Betrachtung in einem Querschnitt aus zwei ersten Gate-Isolator-Gebieten (41) mit der größeren dielektrischen Kapazität und aus einem zentralen, zweiten Gate-Isolator-Gebiet (42) mit der kleineren dielektrischen Kapazität besteht, **dadurch gekennzeichnet, dass** sich das wenigstens eine Wannengebiet (22) in direktem Kontakt mit nur den ersten Gate-Isolator-Gebieten (41) und nicht mit dem zweiten Gate-Isolator-Gebiet (42) befindet,
- der Gate-Isolator (4, 41, 42) ein erstes Material (M1) und ein zweites Material (M2) umfasst, wobei das zweite Material (M2) eine höhere dielektrische Konstante als das erste Material (M1) aufweist, und
- das zweite Material (M2) eine kontinuierliche Schicht ist, die sich vollständig zwischen der Gate-Elektrode (3) und dem Halbleiterkörper (2) erstreckt.

2. Leistungshalbleitervorrichtung (1) nach dem vorhergehenden Anspruch,
wobei der Halbleiterkörper (2) aus einem Material mit breiter Bandlücke oder aus Siliziumkarbid oder aus Silizium ist.

3. Leistungshalbleitervorrichtung (1) nach dem vorhergehenden Anspruch,
- die Leistungshalbleitervorrichtung (1) ein Feldeffekttransistor oder ein Bipolartransistor mit isoliertem Gate ist.

4. Leistungshalbleitervorrichtung (1) nach einem der vorhergehenden Ansprüche,
wobei sich das erste Material (M1) auf einer Seite des zweiten Materials (M2) entfernt von dem Halbleiterkörper (2) befindet, wobei sich der Halbleiterkörper (2) in direktem Kontakt mit dem zweiten Material (M2) befindet, aber nicht mit dem ersten Material (M1), und
wobei die kontinuierliche Schicht des zweiten Materials (M2) eine konstante geometrische Schichtdicke aufweist.

5. Leistungshalbleitervorrichtung (1) nach einem der Ansprüche 1 bis 3,
wobei sich das zweite Material (M2) auf einer Seite des ersten Materials (M1) entfernt von dem Halbleiterkörper (2) befindet, so dass sich sowohl das erste Material (M1) als auch das zweite Material (M2) in direktem Kontakt mit dem Halbleiterkörper (2) befinden.

6. Leistungshalbleitervorrichtung (1) nach einem der Ansprüche 1 bis 3,
wobei der Gate-Isolator (4, 41, 42) eine konstante geometrische Dicke aufweist und sich das erste Material (M1) und das zweite Material (M2) nebeneinander in einer gemeinsamen Ebene befinden, und
wobei sich das erste Material (M1) und das zweite Material (M2) in direktem Kontakt mit dem Halbleiterkörper (2) befinden.

7. Leistungshalbleitervorrichtung (1) nach einem der vorhergehenden Ansprüche,
wobei die Gate-Elektrode (3) eine planare Konfiguration aufweist, so dass sich die Gate-Elektrode (3) auf einer oberen Seite (20) des Halbleiterkörpers (2) befindet und die obere Seite (20) von planarer Art ist.

8. Leistungshalbleitervorrichtung (1) nach einem der Ansprüche 1 bis 6,
wobei die Gate-Elektrode (3) eine Grabenkonfiguration aufweist, so dass sich die Gate-Elektrode (3) in einen Graben (5) des Halbleiterkörpers (5) erstreckt, die Gate-Elektrode (3) tiefer in den Halbleiterkörper (2) als das wenigstens eine Wannengebiet (22) reicht und das wenigstens eine Wannengebiet (22) direkt an den Graben (5) angrenzt.

9. Leistungshalbleitervorrichtung (1) nach einem der vorhergehenden Ansprüche,
wobei der Halbleiterkörper ferner ein Drift-Gebiet (23) umfasst,
wobei das Drift-Gebiet (23) und das wenigstens eine Source-Gebiet (21) einen ersten Leitfähigkeitstyp aufweisen und das wenigstens eine Wannengebiet (22) einen zweiten Leitfähigkeitstyp aufweist, der von dem ersten Leitfähigkeitstyp verschieden ist,
wobei das einzige Gebiet des Halbleiterkörpers (2), mit dem sich das zweite Gate-Isolator-Gebiet (42) in Kontakt befindet, das Drift-Gebiet (23) ist, und
wobei sich die ersten Gate-Isolator-Gebiete (41) bei Betrachtung in einem Querschnitt in Kontakt mit dem wenigstens einen Source-Gebiet (21) und mit dem wenigstens einen Wannengebiet (22) sowie mit dem Drift-Gebiet (23) befinden.

10. Leistungshalbleitervorrichtung (1) nach einem der vorhergehenden Ansprüche,
wobei ein Anteil des zweiten Gate-Isolator-Gebiets (42) entlang einer Grenzfläche der Gate-Elektrode (3), die dem Halbleiterkörper (2) zugewandt ist, zwischen 20 % und 80 %, eingeschlossen, einer Gesamtausdehnung der Grenzfläche ist,
wobei sich die ersten Gate-Isolator-Gebiete (41) bei Betrachtung in einem Querschnitt entlang der Grenzfläche symmetrisch um das zweite Gate-Isolator-Gebiet (42) herum befinden.

11. Leistungshalbleitervorrichtung (1) nach einem der vorhergehenden Ansprüche,
wobei die dielektrische Kapazität der ersten Gate-Isolator-Gebiete (41) mindestens 1,4-mal und höchstens 6-mal die dielektrische Kapazität des zweiten Gate-Isolator-Gebiets (42) ist.

12. Leistungshalbleitervorrichtung (1) nach einem der vorhergehenden Ansprüche,
wobei eine gesamte geometrische Dicke des Gate-Isolators (4, 41, 42) zwischen 10 nm und 1,5 µm, eingeschlossen, beträgt.

13. Leistungshalbleitervorrichtung (1) nach einem der vorhergehenden Ansprüche,
die wenigstens zwei Source-Gebiete (21) und eine Source-Elektrode (31) umfasst, die sich in elektrischem Kontakt mit den wenigstens zwei der Source-Gebiete (21) befindet, wobei bei Betrachtung in einem Querschnitt
- sich die Gate-Elektrode (3) zwischen zwei der wenigstens zwei Source-Gebiete (21) befindet,
- die Source-Elektrode (31) die Gate-Elektrode (3) auf einer Seite entfernt von dem Halbleiterkörper (2) bedeckt, so dass die Source-Elektrode (31) eine gemeinsame Elektrode für die wenigstens zwei Source-Gebiete (21) ist.

## Revendications

1. Dispositif semi-conducteur de puissance (1) comprenant :
- un corps semi-conducteur (2),
- au moins une région de source (21) dans le corps semi-conducteur (2),
- une électrode de grille (3) au niveau du corps semi-conducteur (2),
- un isolant de grille (4, 41, 42) entre le corps semi-conducteur (2) et l'électrode de grille (3), et
- au moins une région de puits (22) au niveau de l'au moins une région de source (21) et au niveau de l'isolant de grille (4, 41, 42), dans lequel
- l'isolant de grille (4, 41, 42) possède une capacité diélectrique variable, la capacité diélectrique est dans chaque cas un quotient d'une constante diélectrique et d'une épaisseur géométrique de l'isolant de grille (4, 41, 42) à un emplacement spécifique de celui-ci,
- la capacité diélectrique est plus grande au niveau de l'au moins une région de puits (22) que dans les régions restantes de l'isolant de grille (4, 42),
- observé en coupe transversale, l'isolant de grille (4, 41, 42) est composé de deux premières régions d'isolant de grille (41) ayant la plus grande capacité diélectrique et d'une deuxième région, centrale, d'isolant de grille (42) ayant la plus petite capacité diélectrique, **caractérisé en ce que** l'au moins une région de puits (22) est en contact direct uniquement avec les premières régions d'isolant de grille (41), mais pas avec la deuxième région d'isolant de grille (42),
- l'isolant de grille (4, 41, 42) comprend un premier matériau (M1) et un deuxième matériau (M2), le deuxième matériau (M2) possède une plus grande constante diélectrique relative que le premier matériau (M1), et
- le deuxième matériau (M2) est une couche continue s'étendant entièrement entre l'électrode de grille (3) et le corps semi-conducteur (2).

2. Dispositif semi-conducteur de puissance (1) selon la revendication précédente,
dans lequel le corps semi-conducteur (2) est constitué d'un matériau à large bande interdite ou de carbure de silicium.

3. Dispositif semi-conducteur de puissance (1) selon la revendication précédente,
le dispositif semi-conducteur de puissance (1) étant un transistor à effet de champ ou un transistor bipolaire à grille isolée.

4. Dispositif semi-conducteur de puissance (1) selon l'une quelconque des revendications précédentes,
dans lequel le premier matériau (M1) est situé sur un côté du deuxième matériau (M2) distant du corps semi-conducteur (2), dans lequel le corps semi-conducteur (2) est en contact direct avec le deuxième matériau (M2), mais pas avec le premier matériau (M1), et
dans lequel la couche continue du deuxième matériau (M2) possède une épaisseur géométrique de couche constante.

5. Dispositif semi-conducteur de puissance (1) selon l'une quelconque des revendications 1 à 3,
dans lequel le deuxième matériau (M2) est situé sur un côté du premier matériau (M1) distant du corps semi-conducteur (2), de sorte que le premier matériau (M1) et le deuxième matériau (M2) sont tous deux en contact direct avec le corps semi-conducteur (2).

6. Dispositif semi-conducteur de puissance (1) selon l'une quelconque des revendications 1 à 3,
dans lequel l'isolant de grille (4, 41, 42) est d'une épaisseur géométrique constante et le premier matériau (M1) et le deuxième matériau (M2) sont situés l'un à côté de l'autre dans un plan commun, et
dans lequel le premier matériau (M1) et le deuxième matériau (M2) sont en contact direct avec le corps semi-conducteur (2).

7. Dispositif semi-conducteur de puissance (1) selon l'une quelconque des revendications précédentes,
dans lequel l'électrode de grille (3) est d'une configuration plane, de sorte que l'électrode de grille (3) est située sur un côté supérieur (20) du corps semi-conducteur (2) et le côté supérieur (20) est de type plan.

8. Dispositif semi-conducteur de puissance (1) selon l'une quelconque des revendications 1 à 6,
dans lequel l'électrode de grille (3) est d'une configuration en tranchée, de sorte que l'électrode de grille (3) s'étend à l'intérieur d'une tranchée (5) du corps semi-conducteur (5), l'électrode de grille (3) atteint une plus grande profondeur à l'intérieur du corps semi-conducteur (2) que l'au moins une région de puits (22), et l'au moins une région de puits (22) jouxte directement la tranchée (5).

9. Dispositif semi-conducteur de puissance (1) selon l'une quelconque des revendications précédentes,
dans lequel le corps semi-conducteur comprend en outre une région de dérive (23),
dans lequel la région de dérive (23) et l'au moins une région de source (21) sont d'un premier type de conductivité, et l'au moins une région de puits (22) est d'un deuxième type de conductivité différent du premier type de conductivité,
dans lequel la seule région du corps semi-conducteur (2) avec laquelle la deuxième région d'isolant de grille (42) est en contact est la région de dérive (23), et
dans lequel, observées en coupe transversale, les premières régions d'isolant de grille (41) sont en contact avec l'au moins une région de source (21) et avec l'au moins une région de puits (22), ainsi qu'avec la région de dérive (23).

10. Dispositif semi-conducteur de puissance (1) selon l'une quelconque des revendications précédentes,
dans lequel une proportion de la deuxième région d'isolant de grille (42) le long d'une interface de l'électrode de grille (3) faisant face au corps semi-conducteur (2) représente entre 20 % et 80 % inclus d'une étendue totale de ladite interface,
dans lequel, observées en coupe transversale, les premières régions d'isolant de grille (41) sont situées le long de ladite interface symétriquement autour de la deuxième région d'isolant de grille (42).

11. Dispositif semi-conducteur de puissance (1) selon l'une quelconque des revendications précédentes,
dans lequel la capacité diélectrique des premières régions d'isolant de grille (41) représente au moins 1,4 fois et au plus 6 fois la capacité diélectrique de la deuxième région d'isolant de grille (42).

12. Dispositif semi-conducteur de puissance (1) selon l'une quelconque des revendications précédentes,
dans lequel une épaisseur géométrique totale de l'isolant de grille (4, 41, 42) se situe entre 10 nm et 1,5 µm inclus.

13. Dispositif semi-conducteur de puissance (1) selon l'une quelconque des revendications précédentes, comprenant au moins deux régions de source (21) et une électrode de source (31) qui est en contact électrique avec les au moins deux des régions de source (21),
dans lequel, observées en coupe transversale,
- l'électrode de grille (3) est située entre deux des au moins deux régions de source (21), et
- l'électrode de source (31) recouvre l'électrode de grille (3) sur un côté distant du corps semi-conducteur (2), de sorte que l'électrode de source (31) est une électrode commune pour les au moins deux régions de source (21).
